Europäisches Patentamt

European Patent Office

Office européen des brevets

(11) Publication number: **0 219 815 B1**

# EUROPEAN PATENT SPECIFICATION

(45) Date of publication of patent specification: **26.02.92** (51) Int. Cl.5: **H05K 1/02**, H05K 7/06

(21) Application number: **86114322.0**

(22) Date of filing: **16.10.86**

(54) Coaxial interconnection boards and process for making same.

(30) Priority: **18.10.85 US 788834**

(43) Date of publication of application:
**29.04.87 Bulletin 87/18**

(45) Publication of the grant of the patent:
**26.02.92 Bulletin 92/09**

(84) Designated Contracting States:
**CH FR IT LI NL SE**

(56) References cited:
**GB-A- 2 096 834**
**US-A- 3 969 816**

**ELECTRONICS, vol. 59, no. 4, January 1986,
pages 56-57, New York, US "Embedded co-
axial wires speed printed circuit board ".**

(73) Proprietor: **Advanced Interconnection Tech-
nology, Inc.**
**181 Freeman Avenue**
**Islip, NY 11751(US)**

(72) Inventor: **Schieber, Leonard**
**31 Renwick Avenue**
**Huntington, NY 11743(US)**
Inventor: **Plonski, J. Philip**
**36 Browns Road**
**Huntington, NY 11743(US)**
Inventor: **Vignola, Michael**
**No. 9 Sixth Avenue**
**Bayville, NY 11709(US)**
Inventor: **Chin, Benjamin G.**
**16 Choir Drive**
**Westbury, NY 11590(US)**

(74) Representative: **Königseder-Egerer, Claudia D.**
**Zugspitzstrasse 65**
**W-8104 Grainau(DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

This invention relates to a wire scribed interconnection board and a process of manufacture, and more particularly to such interconnection boards wherein at least some of the conductors are coaxial conductors.

The signal conductor of a coaxial conductor is protected by a shield which is electrically connected to the reference potential or "ground". Coaxial conductors contain all of the signal energy inside the shield thus providing a clean uniform environment for signal travel. At the same time, the shield prevents radiation of energy from the signal conductor thus improving signal propagation and reducing electrical interference with other signals in the vicinity.

Although coaxial conductors are recognized as a preferred interconnect medium where high signal switching speeds or digital signal transmission are involved, they are not widely used in interconnection circuit boards because of the problems incurred in properly terminating the signal conductor at the end points of the coaxial conductor. The signal conductor and shield must be electrically isolated from each other at the terminal points. In manual installation of coaxial conductors, the signal conductor is usually terminated by stripping back or removing the shield and insulation and connecting it to the terminal point by soldering, welding.

Termination of the shield is conventionally made by connecting a wire, often called a drain wire, between the shield and a central ground or reference point. This manual approach is, however, not practical where there is a large number of interconnections to be provided on a circuit board.

Wire scribed circuit boards can be produced scribing an insulated wire onto an insulating base by feeding a continuous strand of wire onto the surface and simultaneously affixing it to the base thereby producing a predetermined conductor pattern. Through-holes are then drilled at predetermined terminal points intersecting the end portions of the conductors. At least the walls of the holes are then metallized to electrically connect the wire endpoints to surface terminal pads or later added components.

The process described does, however, not work if coaxial conductors are used as the interconnect medium to be scribed since the signal conductor and shield would become electrically connected and thus short-circuited at the terminal points.

In the process of US patent 3 969 816 lengths of discrete coaxial conductors are placed on a substrate between discrete point locations determined by the matrix apertured substrate. The conductors are anchored within the substrate apertures and the ends then milled flush with the board surface exposing both the shield and the signal conductor. In order to prevent shorting of the signal conductor to the shield at the termination, a ring of dielectric material is placed on the surface, covering the shield. In another embodiment, a selective etching step is used to recess the shield from the surface plane. The patent also discloses terminal point interconnected by insulated conductors which are metallized to create a shield. The conductor termination techniques disclosed in US patent 3 969 816 are all based on having conductor terminations flush with the board surface, thus depending on rather comlicated and defect-prone processing steps.

According to the present invention there is provided a wire scribed circuit board as defined in claim 1.

Coaxial conductor interconnection circuit boards according to the present invention are made by a process as defined in claim 4 using signal conductors surrounded with dielectric insulating material and comprising the steps of

- providing an insulating planar substrate with a plurality of longitudinally and transversely spaced terminal points on the surface thereof;
- scribing at least one insulated signal conductor onto said substrate base following a predetermined pattern;
- providing an outer conductive shield which substantially surrounds said insulated signal conductor;
- providing a conductive ground plane electrically connecting said conductive shields;
- providing clearance areas free of any conductive shield or conductive ground plane in the area surrounding said terminal points;
- exposing the ends of said signal conductor within said clearance areas; and
- electrically connecting said signal conductor ends to said terminal points.

In one embodiment, the coaxial conductors are made by scribing the coaxial conductors onto the board surface following a predetermined pattern between terminal points, by placing holes in the board at the terminal points, by providing clearance areas at the terminal points free of conductors other than the signal conductors, and by selectively connecting the signal conductors to surface terminal pads and/or through holes without shorting to the surrounding shield or ground plane.

According to one embodiment of the invention, preformed coaxial conductors are scribed on a circuit board which is thereafter laser drilled at the predetermined locations of terminal points. The coaxial conductors include a shield consisting either of a thin metallic layer or of a coating of an organic conductor material. After the coaxial conductors have been scribed on the board surface, holes are drilled using laser energy at a wavelength not absorbed by the signal conductor. The same laser drilling may also remove the shield material, the coaxial dielectric material and any surrounding encapsulating material; where necessary, selective etching can be used to remove shield material. The holes are then filled with insulating material to provide insulation at the ends of the shields and a clearance area at the terminal points. The filled holes are subsequently drilled a second time to form smaller holes thus again exposing the signal conductors only. The walls of the thus formed holes may then be metallized to connect the signal conductors to surface terminations, e.g., surface pads.

Another embodiment of the invention using scribed coaxial conductors utilizes selective etch back of the shield to provide effective clearance areas at the terminal points. After the coaxial conductors are scribed and encapsulated, holes are drilled at the terminal points exposing both the shield and the signal conductor on the hole wall. The shield is then etched back from the wall and the hole filled with an insulating material to provide insulation at the ends of the shield. Selective etching of the shield without affecting the signal conductor is achieved by either using an etchant composition which etches the shield material but not the signal conductor, or by electrolytic etching of the shield material. The filled, or partially filled, holes are drilled a second time to expose the signal conductors. This hole may then be metallized to bring the signal conductor to a surface termination or to connect to other components.

In either of the embodiments, the shields of the coaxial conductors are preferably interconnected by a conductive layer. This layer not only interconnects the shields on the interconnection board, but also forms a ground plane.

Figures 1A through 1E are sequential illustrations showing a process for making coaxial interconnection boards wherein preformed coaxial conductors are scribed and terminations are made using double laser drilling.

Figures 2A through 2F are sequential illustrations showing a process for making coaxial interconnection boards using preformed coaxial conductors and wherein terminations are made by drilling and etching back the shield conductors.

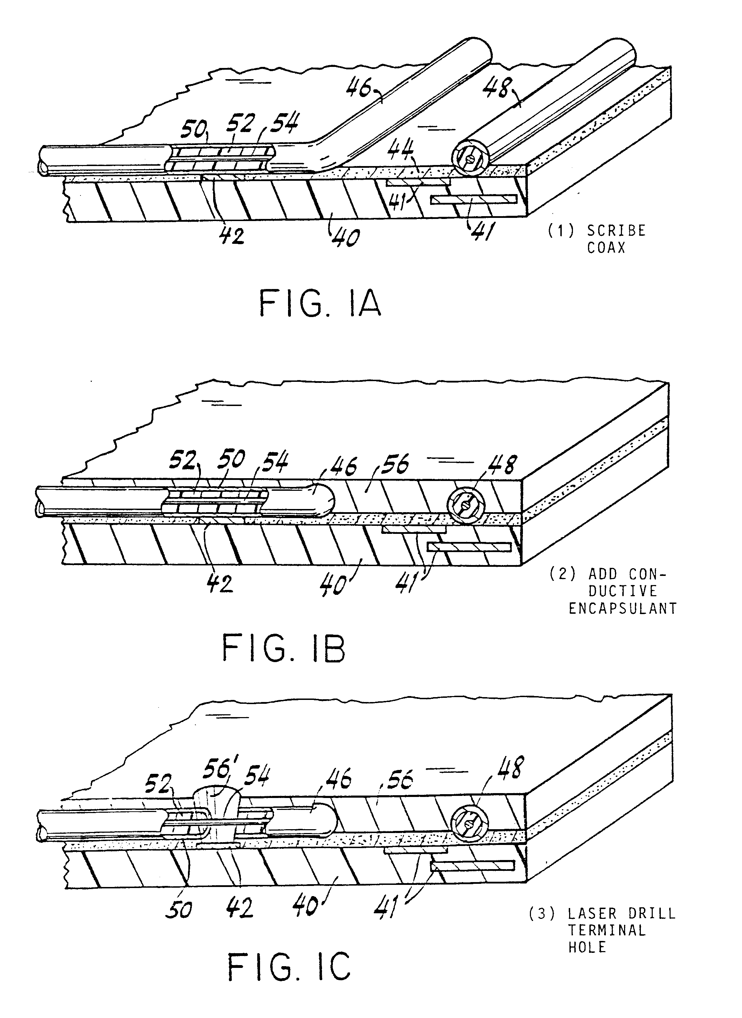

Figs. 1A through 1E describe a sequential process for making coaxial interconnection boards using preformed coaxial conductors. Clearance areas for terminating the coaxial signal conductors are achieved by double drilling, preferably laser drillimg.

A substrate 40 may be of any known type of interconnection board with or without discrete wiring or/and interconnection patterns made by graphic techniques. These interconnection patterns with conductors 41 may be on the surface or may be in the interior as shown. The board surface may include small copper bounce pad areas 42 plated thereon in the terminal areas which will be used to reflect laser energy used in making signal conductor terminations.

The substrate surface is coated with an adhesive 44 and preformed coaxial conductors 46 and 48 are then scribed on the adhesive surface. Preformed coaxial conductors are dispensed by a scribing head which activates the adhesive so as to tack the dispensed wire in place. The adhesive layer preferably has thermo set characteristics so that the coaxial conductors can be permanently set after scribing, for example, by subsequent oven curing.

The coaxial conductors 46,48 include a copper signal conductor 54 in the center surrounded by insulating layer 52. The signal conductor 54 is preferably silver coated. The insulating material 52 preferably has a high resistance and low dielectric constant such as tetrafluoroethylene (TEFLON®). The insulating layer 52 is surrounded with an outer shield 50 which can be of a type removable using laser energy such as (1) a thin vacuum deposited copper layer; (2) a thin plated copper layer; or (3) an organic conductive material. A suitable organic conductive shield material is, e.g., epoxy filled with silver or copper flakes at the ratio of 4 parts metal to 1 part epoxy. A preferred epoxy filled material is EPO-TEK 17® which is a silver flake filled epoxy.

As shown in Fig. 1B, the board is next encapsulated using a conductive material such as the aforementioned copper or silver flake filled epoxy resin. This conductive encapsulant 56 forms a ground plane which interconnects all of the coaxial shield conductors.

The board is next drilled forming a relatively large blind hole 56' as shown in Fig. 1C by using a broadly focussed $CO_2$ laser. Encapsulating layer 56, adhesive layer 44, and insulation 52 of the coaxial conductor, are all organic materials which readily absorb $CO_2$ laser energy at 10.6 microns wavelength and, hence, these materials can be vaporized by the application of such laser energy. Conductive shield 50 is also vaporized either because it is an organic conductive material or because it is a sufficiently thin copper layer. Signal conductor 54 reflects the $CO_2$ laser energy and is relatively unaffected by the laser beam. Copper bounce pad 42 reflects the laser energy upwardly to vaporize organic material underneath the signal conductor 54.

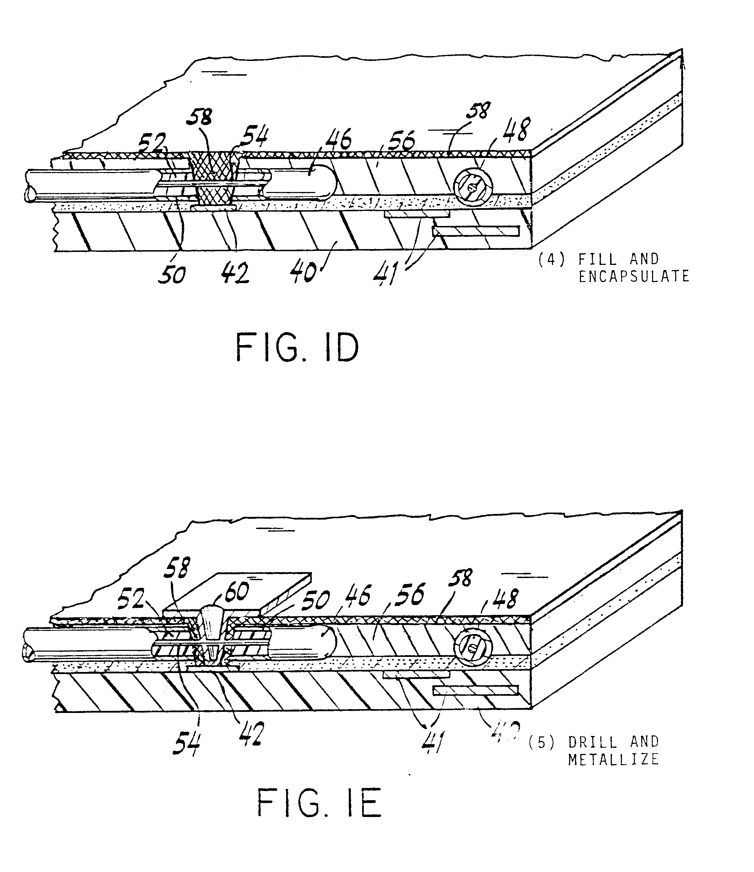

As shown in Fig. 1D, the board is next encapsulated with a non-conductive epoxy layer 58 which fills hole 56' to provide a clearance area free of conductive shield material at the terminal point.

The board is then drilled a second time at the predetermined location to again expose signal conductor 54. The drilling may be mechanical or, as shown in Fig. 1E, by a narrow focussed $CO_2$ laser beam. This hole wall is surrounded by insulating material 58 which isolates the hole from the conductive shield material 50 of the coaxial conductor 46. The board is then subjected to a plating process to form terminal pad 60 at the surface and to metallize the hole(s) thereby connecting signal conductor 54 to the surface terminal pad 60, as shown in Fig. 1E.

The procedure described in Figures 1A through 1E may be modified to include chemical etching which is preferred where a significant quantity of copper is included in either the shield or the ground plane layer interconnecting the shields.

A variation of the described embodiment which provides good results with thin vacuum deposited shields and can provide moderately good results with plated or filled epoxy shields, is as follows:

(1) Scribe the coaxial conductor pattern.

(2) Apply laser energy to remove the shield and dielectric material in the termination areas.

(3) Encapsulate the board using a filled epoxy to form a ground plane.

(4) Supply a mask and then selectively etch to remove filled epoxy in the clearance areas at termination points.

(5) Fill the clearance areas with a non-conductive material.

(6) Drill a small hole, preferably using a focussed laser energy to again expose the copper signal conductor in the clearance area.

(7) Metallize the hole to make a terminal connection.

A second such variation includes the following sequence of process steps:

(1) Scribe the coaxial conductor pattern.

(2) Plate over the coaxial conductors to provide a copper ground plane interconnecting the coaxial shields.

(3) Mask and selectively etch in the clearance areas at the termination points to remove the plated ground plane and the upper portion of the coaxial shield.

(4) Apply laser energy to remove the dielectric in the clearance areas and to expose the signal conductors.

(5) Use additional selective etch if necessary to remove any remaining shield material beneath the signal conductors.

(6) Fill the clearance areas with a non-conductive material.

(7) Drill a small hole, preferably using a focussed laser energy beam to again expose the copper signal conductors in the termination areas.

(8) Metallize the hole to make a terminal connection.

The signal conductors are silver coated and thus resistant to most common copper etching solutions during the etching steps.

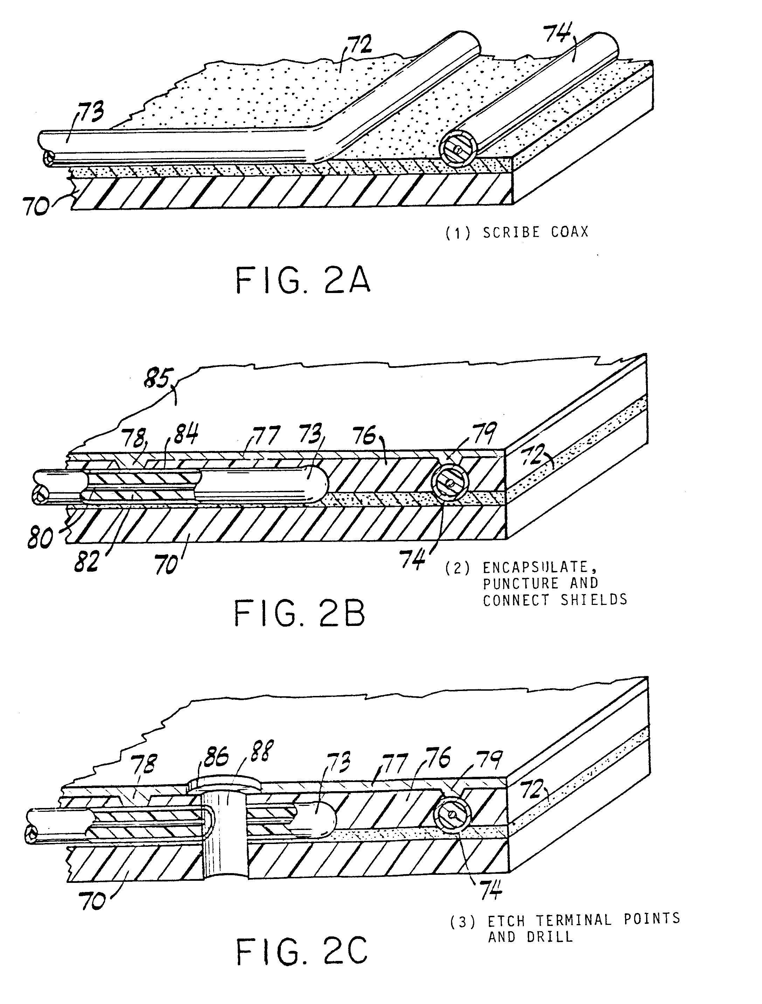

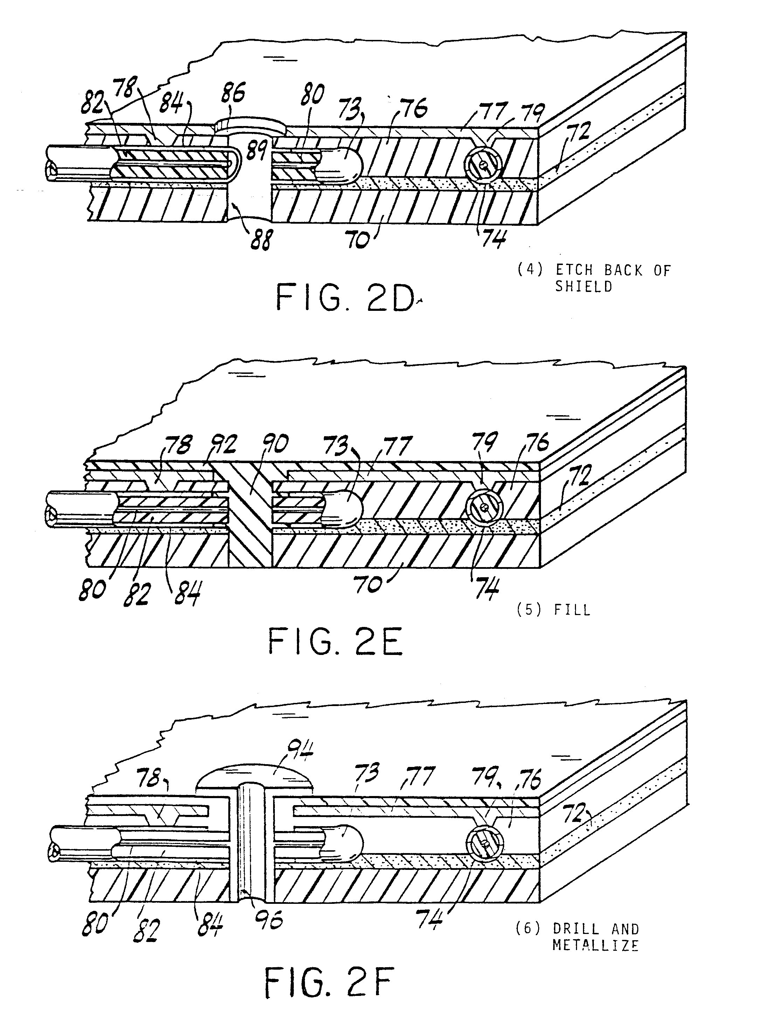

Another process for making a coaxial interconnection board using preformed coaxial conductors is illustrated in Figs. 2A through 2F. In this process, the clearance areas at the signal conductor terminations are created by drilling and a selective etch-back step of the conductors.

As shown in Fig. 2A, the substrate 70, which may include interior and/or surface conductors, ground or power planes (not shown) is coated with an adhesive layer 72. Coaxial conductors 73 and 74 are scribed on the surface and tacked into position using the procedure generally described hereinbefore. The substrate 70 is mounted on an X-Y table and moved relative to a scribing head which dispenses the coaxial conductor. The adhesive is activated as the conductor comes into contact with the board surface by applying energy, such as ultrasonic energy through a suitable ultrasonic stylus.

The interconnection board 70 is then encapsulated using a suitable resin 76, as shown in Fig. 2B, and is subsequently punctured at selected points to expose the coaxial shields 84. As can be seen in the cutaway section, signal conductor 80 is surrounded by dielectric 82 which, in turn, is surrounded by a conductive shield 84.

Punctures in the encapsulating layer 76, such as 78 and 79, are preferably made using a $CO_2$ laser since the laser energy (at about 10.6 microns wavelength) is readily absorbed by the organic resin encapsulating material, but is reflected and not absorbed by the conductive shield 84. Thus, the punctures 78, 79 expose the metallic shield 84 of the coaxial conductors 73,74 through the encapsulating layer 76. The board is then coated by a conductive layer 85 which fills punctures 78,79 so that all of the coaxial shields are connected to a common ground plane 77.

As shown in Fig. 2C, the interconnection board is next selectively etched to remove conductive material 77 in the vicinity of the terminal points. Selective etching in the terminal areas can be achieved in known ways by employing a photoresist mask as an etch-resist thus providing clearance areas 86. A hole 88 is then drilled at the center of clearance area 86 to expose signal conductor 80 and conductive shield 84 on the wall of the hole 88.

The conductive shield is next etched-back from the hole wall as shown in Fig. 2D. The selective etching can be achieved by using a different conductive material for signal conductor 80 and conductive shield 84 in combination with an etching solution which affects only the shield material. For example, the central signal conductor 80 may be copper and the outer shield conductor 84 aluminum which can be selectively etched using sodium hydroxide as an etchant. Alternatively, the signal conductor 80 may be a noble metal such as gold, silver or palladium silver, or plated with such metal, and the shield conductor 84 may be made of copper or other less noble metal. In this case, common etchants such as persulfates or ammonical copper chloride can be used.

Another method for selectively etching back the outer shield is to use an electrolytic etching process. This is particularly convenient with all of the conductive shields on the interconnection board previously interconnected to common ground plane 77. The shields can be electrolytically etched by applying a potential between the ground shield and a counter electrode in the etching bath solution. The signal conductors are not electrically connected and are, therefore, unaffected. If both the signal conductor and shield conductors are copper, a suitable etching solution is a sulfuric acid copper sulfate solution. The selective etching step forms cavities 89 and thus provides a conductive shield clearance area at the terminal points.

After the shields have been etched back, the board is provided with an encapsulation layer 92 of a non-conductive resin material which, at 90, also fills the hole 88 including the cavity 89 created by etching back the shieldconductors. Preferably prior to encapsulation the exposed ends of the shield conductors are coated electrophoretically by placing the circuit board in an electrophoretic plating bath suspension and connecting the outer shield conductors to be electrically charged thus causing electrolytic precipitation of insulating material on the charged surfaces.

As shown in Fig. 2F the board is then drilled a second time thereby forming a hole of the same or slightly larger size compared to the first drilled hole 88 maintaining the original hole registry. This hole, again, exposes the end of the signal conductor 80. The shield conductors 84, however, have previously been etched back to provide a clearance area at the terminal point and are therefore not exposed on the hole wall. The hole wall is then metallized and surface pads 94 formed by a plating process thus connecting the signal conductor 80 to the surface pad metal layer 96.

Although specific embodiments have been described for making single sided coaxial interconnection boards, the techniques according to the invention are equally applicable for making interconnection boards provided with coaxial conductors on both sides or interconnection boards with multi-layered coaxial conductors.

The techniques utilized for signal conductor terminations may be used to bring the signal conductor terminations to the surface or to interconnect with other interior or surface conductors. Furthermore, additional interconnecting layers can be formed over the coaxial conductor layers, if desired.

Scribing conductors can be achieved by either placing the adhesive coating on the board surface of by emplying adhesive coated conductors.

Other techniques for forming the conductive layer interconnecting the shields may also be employed. The invention is more particularly defined in the appended claims.

## Claims

1. A wire scribed circuit board comprising an insulating planar substrate (40, 70) provided with a conductive ground plane; a plurality of terminal points (60, 94) on the surface of said substrate; at least one elongated preformed signal conductor (54, 80) surrounded by an insulating coating (52, 82) extending along its lengths and a conductive shield (50, 84) external to said insulating coating to form a coaxial conductor; each terminal point being surrounded by an area which is free of any conductive material other than said signal conductor; said conductive sheild (50, 84) being electrically connected to said ground plane (56, 85); and said signal conductor being adhered to said substrate following a predetermined path between terminal points and being terminated within said areas free of said conductive shields.

2. The wire scribed circuit board of claim 1 wherein said conductor is a preformed coaxial conductor.

3. The wire scribed circuit board of claim 1 or claim 2 wherein conductive material is removed by etching, exposure to laser energy or drilling, or by a combination thereof, to form, at least in part, said clearance areas.

4. A process for manufacturing a coaxial conductor circuit board using signal conductors (54, 80) surrounded with dielectric insulating material (52, 82), the process comprising
   - providing an insulating planar substrate base (40, 70) with a plurality of longitudinally and transversely spaced terminal points (60, 94) on the surface thereof;
   - scribing at least one insulated signal conductor (54, 80) onto said substrate base following a predetermined pattern;
   - providing an outer conductive shield (50, 84) which substantially surrounds said insulated signal conductor;
- providing a conductive ground plane (56, 85) electrically connecting said conductive shields;
- providing clearance areas free of any conductive shield or conductive ground plane in the area surrounding said terminal points (60, 94);
- exposing the ends of said signal conductor within said clearance areas; and
- electrically connecting said signal conductor ends to said terminal points.

5. The process of claim 4 wherein said substrate and/or said coaxial conductor is/are coated with an adhesive (44) and wherein said signal conductor is affixed by activating said adhesive as said signal conductor is being scribed.

6. The process of claim 5 wherein said clearance areas are provided, at least in part, by drilling the board at the terminal points and selectively etching conductive material other than said signal conductor away from the hole wall.

7. The process of claim 5 wherein said clearance areas are provided, at least in part, by selectively removing material other than said signal conductor using laser energy.

8. The process of claims 4 or 5 further comprising coating the side of said board provided with said coaxial conductors with a conductive material (56) after scribing said coaxial conductors to interconnect the outer conductive shields thereof; using laser energy to remove material at a terminal point to expose the signal conductor at the terminal point; applying insulating material (58) to any conductive material other than the signal conductor which is exposed at said terminal point; and drilling a hole at said terminal point to again expose said signal conductor.

9. The process of claim 8 wherein said coating of conductive material is a plated copper layer and wherein plated copper is removed at said terminal point by etching.

10. The process of claim 9 wherein shield material of said coaxial conductors above said signal conductor is removed by etching before application of said laser energy and wherein shield material below said signal conductor is removed by etching after application of said laser energy.

11. The process of claim 8 wherein said hole at said terminal point is drilled by laser drilling.

12. The process of claim 11 wherein said laser energy used to remove material drills a first hole and a second laser drilling step is employed to again expose said signal conductor and providing a second hole smaller in diameter than said first hole.

13. The process of claim 12 wherein insulating material is applied to exposed conductive material in said first hole by filling said hole and coating the board with a non-conductive resin material.

14. The process of claim 8 wherein a metallic laser energy bounce pad is provided beneath said signal conductor at said terminal point.

15. The process of claim 8 wherein said drilled hole is exposed to a metallizing process to form a signal conductor connection to the surface of the board at the terminal point.

16. The process of one or more of the preceeding claims 4 to 15 wherein the signal conductor is a noble metal, said conductive shield is a less noble metal, and said etchant is selective toward the less noble metal.

17. The process of one or more of the preceeding claims 4 to 16 wherein the signal conductor is copper, the conductive shield is aluminum and the etchant is sodium hydroxide.

18. The process of one or more of the preceeding claims 4 to 16 wherein said etching back is achieved by electrically connecting to the conductive shield to electrolytically etch the conductive shield using an electrolytic etch.

19. The process of claim 18 wherein the conductive shield is copper and said electrolytic etch is a sulfuric acid copper sulfate solution.

20. The process of one or more of the preceeding claims 4 to 16 wherein the scribed coaxial conductors are coated with an encapsulating resin, said resin coating is punctured to expose sections of the conductive shield, and wherein the coating of conductive material is thereafter applied to interconnect the conductive shields via said punctures.

21. The process of one or more of the preceeding claims wherein insulating material is applied to the exposed ends of said etched back conductive material electrophoretically.

**22.** The process of one or more of the preceeding claims 4 to 16 wherein said holes are filled with an insulating material after said etching back and thereafter drilled again to provide a hole of a diameter selected to expose only the signal conductor.

**Revendications**

**1.** Carte de circuit à fils incrustés comprenant un substrat isolant plan (40, 70) muni d'un plan de masse conducteur; une pluralité de points terminaux (60, 94) sur la surface dudit substrat; au moins un conducteur de signal préalablement formé allongé (54, 80) entouré d'un revêtement isolant (52, 82) s'étendant dans le sens de ses longueurs et un blindage conducteur (50, 84) extérieur audit revêtement isolant pour former un conducteur coaxial, chaque point terminal étant entouré d'une zone qui est exempte de matériaux conducteurs autres que ledit conducteur de signal; ledit blindage conducteur (50, 84) étant électriquement connecté audit plan de masse (56, 85); et ledit conducteur de signal adhérant audit substrat suivant un trajet déterminé entre les points terminaux et étant terminé dans lesdites zones exemptes desdits blindages conducteurs.

**2.** Carte de circuit à fils incrustés selon la revendication 1, dans laquelle ledit conducteur est un conducteur coaxial préalablement formé.

**3.** Carte de circuit à fils incrustés selon la revendication 1 ou 2, dans lequel le matériau conducteur est retiré par attaque, exposition à de l'énergie laser ou perforation, ou par une combinaison de ces méthodes, pour former, au moins partiellement, lesdites zones de séparation.

**4.** Procédé de fabrication d'une carte de circuit pour conducteurs coaxiaux utilisant lesdits conducteurs de signaux (54, 80) entourés d'un matériau isolant diélectrique (52, 82), le procédé comprenant les opérations consistant à:
- munir un substrat de base isolant plan (40, 70) d'une pluralité de points terminaux espacés longitudinalement et transversalement (60, 94) sur sa surface;
- incruster au moins un conducteur de signal isolé (54, 80) sur ledit substrat de base suivant un motif prédéterminé;
- réaliser un blindage conducteur extérieur (50, 84) qui entoure sensiblement ledit conducteur de signal isolé;

- réaliser un plan de masse conducteur (56, 85) connectant électriquement lesdits blindages conducteurs;
- réaliser des zones de séparation exemptes de blindage conducteur ou de plan de masse conducteur dans la zone entourant lesdits points terminaux (60, 94),
- exposer les extrémités dudit conducteur de signal dans lesdites zones de séparation; et
- connecter électriquement lesdites extrémités de conducteurs de signaux auxdits points terminaux.

**5.** Procédé selon la revendication 4, dans lequel ledit substrat et/ou ledit conducteur coaxial est/sont revêtu(s) d'un adhésif (44) et dans lequel ledit conducteur de signal est fixé par activation dudit adhésif lors de l'incrustation dudit conducteur de signal.

**6.** Procédé selon la revendication 5, dans lequel lesdites zones de séparation sont réalisées, au moins en partie, par perforation de la carte aux points terminaux et attaque sélectivement du matériau conducteur autre que ledit conducteur de signal pour l'éliminer de la paroi des trous.

**7.** Procédé selon la revendication 5, dans lequel lesdites zones de séparation sont réalisées, au moins en partie, par élimination sélective du matériau autre que ledit conducteur de signal à l'aide d'énergie laser.

**8.** Procédé selon les revendications 4 ou 5, comprenant en outre l'application sur la face de ladite carte qui est munie desdits conducteurs coaxiaux, d'un matériau conducteur (56) après incrustation desdits conducteurs coaxiaux pour interconnecter leurs blindages conducteurs extérieurs; l'utilisation d'énergie laser pour retirer le matériau du point terminal afin d'exposer le conducteur de signal au point terminal; l'application d'un matériau isolant (58) à tous les matériaux conducteurs autres que le conducteur de signal qui est exposé audit point terminal; et le perçage d'un trou audit point terminal pour exposer de nouveau ledit conducteur de signal.

**9.** Procédé selon la revendication 8, dans lequel ledit revêtement de matériau conducteur est une couche de cuivre plaquée et dans lequel le cuivre plaqué est retiré au dit point terminal par attaque.

**10.** Procédé selon la revendication 9, dans lequel le matériau de blindage desdits conducteurs coaxiaux se trouvant au-dessus dudit conducteur de signal, est retiré par attaque avant application de ladite énergie laser et dans lequel le matériau de blindage situé sous ledit conducteur de signal est retiré par attaque après application de ladite énergie laser.

11. Procédé selon la revendication 8, dans lequel ledit trou se trouvant audit point terminal est percé par perçage au laser.

12. Procédé selon la revendication 11, dans lequel ladite énergie laser utilisée pour retirer le matériau perce un premier trou et dans lequel une seconde étape de perçage au laser est utilisée pour exposer de nouveau ledit conducteur de signal et réaliser un second trou de diamètre inférieur à celui dudit premier trou.

13. Procédé selon la revendication 12, dans lequel un matériau isolant est appliqué au matériau conducteur exposé dans ledit premier trou par remplissage dudit trou et application sur la carte d'un matériau résineux non conducteur.

14. Procédé selon la revendication 8, dans lequel une pastille métallique de réflection d'énergie laser est réalisée sous ledit conducteur de signal audit point terminal.

15. Procédé selon la revendication 8, dans lequel ledit trou percé est exposé à un traitement de métallisation pour former une connexion de conducteurs de signaux avec la surface de la carte au point terminal.

16. Procédé selon l'une ou plusieurs des revendications 4 à 15 précédentes, dans lequel le conducteur de signal est un métal noble, ledit blindage conducteur est un métal moins noble, et ledit décapant est sélectif vis-à-vis du métal moins noble.

17. Procédé selon l'une ou plusieurs des revendications 4 à 16 précédentes, dans lequel le conducteur de signal est le cuivre, le blindage conducteur est l'aluminium et le décapant est l'hydroxyde de sodium.

18. Procédé selon l'une ou plusieurs des revendications 4 à 16 précédentes, dans lequel ladite attaque est effectuée par connexion électrique au blindage conducteur pour attaquer électrolytiquement le blindage conducteur par attaque électrolytique.

19. Procédé selon la revendication 18, dans lequel le blindage conducteur est le cuivre et ledit décapant électrolytique est une solution de sulfate de cuivre et d'acide sulfurique.

20. Procédé selon l'une ou plusieurs des revendications 4 à 16 précédentes, dans lequel les conducteurs coaxiaux incrustés sont revêtus d'une résine d'encapsulation, ledit revêtement de résine est perforé pour exposer des sections du blindage conducteur, et le revêtement de matériau conducteur est ensuite appliqué pour interconnecter les blindages conducteurs au travers desdites perforations.

21. Procédé selon l'une ou plusieurs des revendications précédentes, dans lequel un matériau isolant est appliqué de façon électrophorétique aux extrémités exposées dudit matériau conducteur de nouveau attaqué.

22. Procédé selon l'une ou plusieurs des revendications 4 à 16 précédentes, dans lequel lesdits trous sont percés avec un matériau isolant après ladite seconde attaque puis de nouveau percé pour réaliser un trou de diamètre sélectionné afin de n'exposer que le conducteur de signal.

**Patentansprüche**

1. Eine drahtgeschriebene Schaltungsplatte, bestehend aus einem isolierenden planen Träger (40, 70) mit einer leitfähigen Schicht, die als Masse dient; einer Vielzahl von Anschlußkontaktpunkten (60, 94) auf der Oberfläche des genannten Trägers; mindestens einem, von einer isolierenden Schicht (52, 82) über dessen gesamte Länge umgebenen, länglichen, vorgeformten Signalleiter (54, 80) und einer leitfähigen Abschirmung (50, 84) außerhalb der genannten isolierenden Schicht, die zusammen einen Koaxialleiter bilden; und bei der jeder der Anschlußkontaktpunkte von einer Zone umgeben ist, die, abgesehen vom Signalleiter selbst, frei von leifähigem Material ist; die leitfähige Abschirmung (50, 84) elektrisch mit der als Masse dienenden leitfähigen Schicht (56, 85) verbunden ist; jeder Signalleiter auf dem Träger entsprechend einem vorgegebenen Weg zwischen Anschlußkontaktpunkten befestigt ist und in den genannten, von leitfähigem Material freien Zonen endet.

2. Die drahtgeschriebene Schaltungsplatte nach Anspruch 1, bei der der genannte Signalleiter ein vorgeformter Koaxialleiter ist.

3. Die drahtgeschriebene Schaltungsplatte nach Anspruch 1 oder Anspruch 2, bei der leitfähiges Material durch Ätzen, die Einwirkung von Laserenergie oder Bohren, oder durch eine Kombination der genannten Verfahren, entfernt wird, um zumindest teilweise die genannten Freizonen herzustellen.

4. Ein Verfahren zum Herstellen von Schaltungsplatten mit koaxialen Leiterzügen unter Verwendung von Signalleitern (54, 80), die mit einem dielektrischen Isoliermaterial (52, 82) umgeben sind, gekennzeichnet durch die folgenden Verfahrensschritte:
   - Versehen der Oberfläche eines planen Trägers aus Isolierstoffmaterial (40, 70) mit einer Vielzahl von in Längs- und Querrichtung angeordneten Anschlußkontaktpunkten (60, 94);
   - Schreiben mindestens eines isolierten Signalleiters (54, 80) auf den genannten Träger in einem vorgegebenen Muster;
   - Anbringen einer äußeren leitfähigen Abschirmung (50, 84), die den isolierten Signalleiter praktisch vollständig umgibt;
   - Anbringen einer leitfähigen, als Masse dienenden Schicht (56, 85), die die Abschirmungen elektrisch miteinander verbindet;
   - Herstellen von Freizonen in den die Anschlußkontaktpunkte (60, 94) umgebenden Bereichen, die frei von jeglicher elektrischer Abschirmung oder leitfähiger, als Masse dienenden Schicht sind;
   - Freilegen der Signalleiterenden innerhalb der Freizonen; und
   - Herstellen von elektrisch leitenden Verbindungen zwischen den Signalleiterenden und den Anschlußkontaktpunkten.

5. Das Verfahren nach Anspruch 4, bei dem der Träger und/oder die Koaxialleiter mit einem Haftvermittler (44) versehen ist/sind, und bei dem der Signalleiter durch Aktivieren des Haftvermittlers während des Schreibens des Signalleiters fixiert wird.

6. Das Verfahren nach Anspruch 5, bei dem die Freizonen, zumindest teilweise, durch Bohrungen in den Anschlußkontaktpunkten und selektives Ätzen, mit Ausnahme des Signalleiters, von leitfähigem Material von den Lochwandungen hergestellt werden.

7. Das Verfahren nach Anspruch 5, bei dem die Freizonen, zumindest teilweise, durch selektives Entfernen von Material mit Ausnahme des Signalleiters mittels Laserenergie hergestellt werden.

8. Das Verfahren nach den Ansprüchen 4 oder 5, bei dem weiterhin die mit den Koaxialleitern versehene Seite des Trägers nach dem Aufbringen der Koaxialleiter mit einem leitfähigen Material (56) versehen wird, um die äußeren leitfähigen Abschirmungen untereinander zu verbinden; Laserenergie verwendet wird zum Entfernen von Material in einem Anschlußkontaktpunkt zum Freilegen des Signalleiters in diesem Punkt; ein isolierendes Material (58) auf dem gesamten leitfähigen Material mit Ausnahme des Signalleiters, der in dem Anschlußkontaktpunkt freiliegt, aufgebracht wird; und ein Loch im Anschlußkontaktpunkt gebohrt wird, um den Signalleiter erneut freizulegen.

9. Das Verfahren nach Anspruch 8, bei dem das die leitfähige Schicht bildende Material eine aufplattierte Kupferschicht ist, und das aufplattierte Kupfer in den Anschlußkontaktpunkten durch Ätzen entfernt wird.

10. Das Verfahren nach Anspruch 9, bei dem Abschirmmaterial der Koaxialleiter oberhalb des Signalleiters durch Ätzen vor der Anwendung von Laserenergie entfernt wird, und Abschirmmaterial unterhalb des Signalleiters durch Ätzen nach der Anwendung von Laserenergie.

11. Das Verfahren nach Anspruch 8, bei dem das Loch im Anschlußkontaktpunkt durch Bohren mittels Laserenergie hergestellt wird.

12. Das Verfahren nach Anspruch 11, bei dem mit der zum Entfernen von Material verwendeten Laserenergie zunächst ein erstes Loch gebohrt wird, und ein zweiter Bohrvorgang mittels Laserenergie zum Freilegen des Signalleiters und Herstellen eines zweiten Loches dient, dessen Durchmesser geringer ist als der des ersten Loches.

13. Das Verfahren nach Anspruch 12, bei dem isolierendes Material auf im ersten Loch freiliegendes leitfähiges Material aufgebracht wird durch Füllen dieses Loches, und die gesamte Leiterplatte mit einem nicht-leitfähigen Harzmaterial überzogen wird.

14. Das Verfahren nach Anspruch 14, bei dem ein metallisches Laserenergie-Reflektionsplättchen unter dem Signalleiter im Anschlußkontaktpunkt angebracht ist.

15. Das Verfahren nach Anspruch 8, bei dem das gebohrte Loch einem Metallisierungsverfahren unterzogen wird, um eine elektrische Verbindung zwischen dem Signalleiter und der Oberfläche der Schaltungsplatte im Anschlußkontaktpunkt herzustellen.

16. Das Verfahren nach einem oder mehreren der vorangehenden Ansprüche 4 bis 15, bei dem der Signalleiter aus einem Edelmetall besteht, die leitfähige Abschirmung aus einem weniger edlen Metall und das Ätzmittel nur das weniger edle Metall angreift.

17. Das Verfahren nach einem oder mehreren der vorangehenden Ansprüche 4 bis 16, bei dem der Signalleiter aus Kupfer besteht und die Abschirmung aus Aluminium, und das Ätzmittel Natriumhydroxid ist.

18. Das Verfahren nach einem oder mehreren der vorangehenden Ansprüche 4 bis 16, bei dem das Zurückätzen der leitfähigen Abschirmungen auf elektrolytischem Wege erfolgt.

19. Das Verfahren nach Anspruch 18, bei dem die Abschirmung aus Kupfer besteht und als Elektrolyt eine schwefelsaure Kupfersulfatlösung dient.

20. Das Verfahren nach einem oder mehreren der vorangehenden Ansprüche 4 bis 16, bei dem die koaxialen Leiterzüge mit einem Vergußharz überzogen werden, dieser Harzüberzug gelocht wird, um Abschnitte der leitfähigen Abschirmung freizulegen, und nachfolgend die Schicht aus leitfähigem Material aufgebracht wird, um die leitfähigen Abschirmungen untereinander über die freigelegten Abschnitte zu verbinden.

21. Das Verfahren nach einem oder mehreren der vorangehenden Ansprüche, bei dem auf die freigelegten Enden des zurückgeätzten leitfähigen Materials Isoliermaterial auf elektrophoretischem Wege aufgebracht wird.

22. Das Verfahren nach einem oder mehreren der vorangehenden Ansprüche 4 bis 16, bei dem die genannten Löcher nach dem Zurückätzen mit einem Isoliermaterial gefüllt und anschließend erneut gebohrt werden, um ein Loch mit einem solchen Durchmesser herzustellen, daß nur der Signalleiter freiliegt.

FIG. IA

(1) SCRIBE
    COAX

FIG. IB

(2) ADD CON-
    DUCTIVE
    ENCAPSULANT

FIG. IC

(3) LASER DRILL
    TERMINAL
    HOLE

EP 0 219 815 B1

(4) FILL AND
ENCAPSULATE

FIG. ID

(5) DRILL AND
METALLIZE

FIG. IE

73 72 74

(1) SCRIBE COAX

# FIG. 2A

85

78 84 77 73 76 79 72

80

82 70

74

(2) ENCAPSULATE,
PUNCTURE AND
CONNECT SHIELDS

# FIG. 2B

78 86 88 73 77 76 79 72

70

74

(3) ETCH TERMINAL POINTS
AND DRILL

# FIG. 2C

FIG. 2D

(4) ETCH BACK OF SHIELD

FIG. 2E

(5) FILL

FIG. 2F

(6) DRILL AND METALLIZE